(19) Europäisches Patentamt

European Patent Office

Office européen des brevets

(11) Veröffentlichungsnummer: **0 193 212 B1**

(12) **EUROPÄISCHE PATENTSCHRIFT**

(45) Veröffentlichungstag der Patentschrift: **10.06.92**

(21) Anmeldenummer: **86102682.1**

(22) Anmeldetag: **01.03.86**

(51) Int. Cl.⁵: $G01R\ 23/00$, H02P 5/402

(54) Verfahren zum Verarbeiten eines als eine Frequenz vorliegenden Messwertes.

(30) Priorität: **01.03.85 DE 8506353 U**

(43) Veröffentlichungstag der Anmeldung:
**03.09.86 Patentblatt 86/36**

(45) Bekanntmachung des Hinweises auf die
Patenterteilung:
**10.06.92 Patentblatt 92/24**

(84) Benannte Vertragsstaaten:
**AT BE CH DE FR GB IT LI LU NL SE**

(56) Entgegenhaltungen:
**DE-B- 2 155 834**
**GB-A- 2 079 986**
**US-A- 4 215 315**
**US-A- 4 348 625**

(73) Patentinhaber: **Joh. Vaillant GmbH u. Co.**
**Berghauser Strasse 40 Postfach 10 10 61**
**W-5630 Remscheid(DE)**

(84) Benannte Vertragsstaaten:
**DE IT LU SE**

(73) Patentinhaber: **n.v. Vaillant s.a.**
**rue Golden Hopestraat 15**
**B-1620 Drogenbos(BE)**

(84) Benannte Vertragsstaaten:
**BE**

(73) Patentinhaber: **VAILLANT S.A.R.L**
**4, Rue des Oliviers Orly-Sénia 326**
**F-94537 Rungis Cedex(FR)**

(84) Benannte Vertragsstaaten:
**FR**

(73) Patentinhaber: **VAILLANT Ges.m.b.H**
**Forchheimergasse 7 Postfach 56**
**A-1233 Wien(AT)**

(84) Benannte Vertragsstaaten:
**AT**

(73) Patentinhaber: **Vaillant Ltd.**
**Vaillant House Medway City Estate Trident**
**Close**
**Rochester Kent ME2 4EZ(GB)**

(84) Benannte Vertragsstaaten:
**GB**

(73) Patentinhaber: **Vaillant-Schonewelle B.V.**
**Paasheuvelweg 42 Postbus 23250**
**NL-1100 DT Amsterdam(NL)**

(84) Benannte Vertragsstaaten:
**NL**

(73) Patentinhaber: **Vaillant GmbH**
**Riedstrasse 8**
**CH-8953 Dietikon 1(CH)**

(84) Benannte Vertragsstaaten:
**CH LI**

(72) Erfinder: **Hangauer, Wilfried, Dr.**
**Heidenstrasse 15**
**W-5609 Hückeswagen(DE)**

(74) Vertreter: **Heim, Johann-Ludwig**
**c/o Joh. Vaillant GmbH u. Co Postfach 10 10**
**20 Berghauser Strasse 40**
**W-5630 Remscheid 1(DE)**

## Beschreibung

Die vorliegende Erfindung bezieht sich auf ein Verfahren zum Verarbeiten eines als Frequenz vorliegenden Meßwertes und auf eine Schaltung zur Durchführung des Verfahrens gemäß dem Oberbegriff des Anspruchs 1.

Es gibt eine Vielzahl von Anwendungsfällen für Meßverfahren, bei denen die Meßwerte als Frequenzen vorliegen. Hierbei kämen Einrichtungen zur Wärmemengenmessung genauso in Frage wie Drehzahlsteuerung oder Regelung von Elektromotoren. Wenn ein solcher Meßwert lediglich als Frequenz vorliegt, besteht eine erhebliche Schwierigkeit bei einer analogen Verarbeitung im Hinblick auf das Erreichen eines analogen Spannungs- oder Stromwertes, der die Frequenz repräsentiert.

Aus der US-A-4 215 315, von der ausgehend jeweils der Obergegriff der vorliegenden Ansprüche 1 und 9 gebildet worden ist, ist zur Lösung dieses Problems eine Schaltung bekannt, bei der ein Kondensator in Abhängigkeit von der umzuwandelnden Frequenz aufgeladen wird. Die Aufladung des Kondensators erfolgt quasi als stetige Rampe mittels variablen Konstantstroms. Nachteilig bei diesem Lösungsprinzip ist vor allem, daß der Spannungsanstieg vom Konstantstrom und der Kapazität des Kondensators abhängt, so daß zur Eliminierung der entsprechenden Bauteiltoleranzen abwechselnd Meß- und Kalibrierzyklen durchgeführt werden müssen, wobei eine Mittelwertbildung durch Integration über viele Perioden erforderlich ist. Auch bei einer aus der DE-A-18 05 564 bekannten Vorrichtung zur Messung niedriger Wiederholungsfrequenzen, die eine schaltungstechnische Abwandlung des oben beschriebenen Frequenz-Spannungs-Wandlers darstellt, müssen Konstantstrom- und Kondensatortoleranzen berücksichtigt werden.

Bekannt ist weiterhin ein in der DE-B-21 55 834 beschriebener Frequenz-Spannungs-Wandler, der ebenfalls einen im Takt der Frequenz aufzuladenden Kondensator aufweist, welcher mit Konstantstrom beaufschlagt ist. Aus den resultierenden Sägezahnimpulsen wird eine Gleichspannung hergeleitet und über eine von den Frequenzsignalen angestoßene Kippstufe einem Zwischenspeicherkondensator zugeführt. Auch bei dieser Schaltung gehen die unvermeidlichen Kondensatortoleranzen sowie Ungenauigkeiten der Konstantstromquelle in die Frequenz-Spannungs-Wandlung voll ein.

Ein Frequenz-Spannungs-Wandler als solcher ist gemäß der GB-A-2 079 986 Bestandteil einer Schaltung zur Geschwindigkeitskontrolle eines Motors. Über den Aufbau des Wandlers ist in dieser Druckschrift nichts gesagt.

Der vorliegenden Erfindung liegt daher die Aufgabe zugrunde, ein Verfahren anzugeben, das zu einem quasi analogen Ausgangssignal für den Frequenzwert führt. Die Verwendung von frequenz- beziehungsweise zeitbestimmenden Bauteilen, an die sehr hohe Genauigkeitsanforderungen zu stellen wären, ist dabei zu vermeiden.

Die Lösung der Aufgabe ist im Anspruch 1 angegeben.

Weitere Ausgestaltungen des Verfahrens sind Gegenstand der Ansprüche 2 bis 8. Eine Schaltung zur Durchführung des Verfahrens ist im Anspruch 9 angegeben. Besonders vorteilhafte Weiterbildungen dieser Schaltung beinhalten die Ansprüche 10 bis 13.

Die Erfindung wird anhand der Figuren 1 bis 6 der Zeichnung im folgenden näher erläutert, wobei die Figur 1 ein Prinzipschaltbild, die Figur 2 ein Detail des Prinzipschaltbildes, Figur 3 ein Diagramm und die Figuren 4 bis 6 weitere Ausführungsbeispiele des Details des Prinzipschaltbildes zeigen.

In allen sechs Figuren bedeuten gleiche Bezugszeichen jeweils die gleichen Einzelheiten.

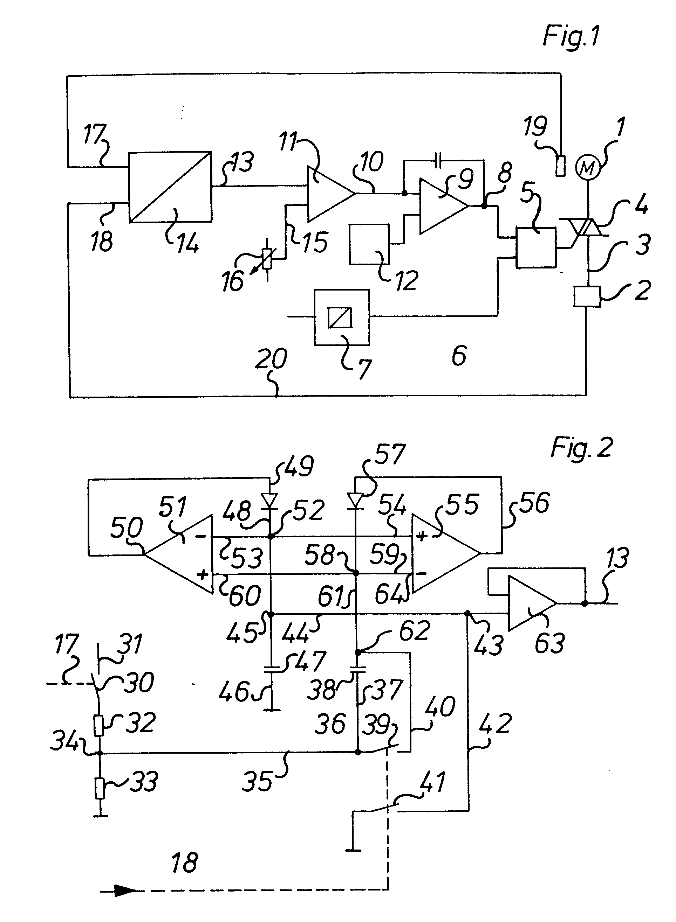

Die Figur 1 hat ein Prinzipschaltbild einer Motordrehzahlregelung zum Inhalt. Ein Asynchron-Elektromotor 1 wird von einer Spannungsquelle 2 im Zuge einer Leitung 3 gespeist, in die ein Triac 4 eingeschleift ist. Bei dem Asynchronmotor kann es sich um einen Spaltpolmotor ebenso wie um einen 3-Phasenmotor handeln, nur sind dann in den verschiedenen Zuleitungen einzelne Triacs vorzusehen mit separater Ansteuerung. Die Zündimpulse für den Triac 4 liefert ein Umsetzer 5, der über eine Leitung 6 vom Netz synchronisiert wird, wofür eine Synchronisationseinrichtung 7 vorgesehen ist. Einen anderen Eingang des Umsetzers bildet eine Leitung 8, die den Ausgang eines Integrators 9 darstellt. Der eine Eingang 10 des Integrators ist Ausgang eines Komparators 11, der andere Eingang des Integrators 9 ist ein Vergleichsspannungsgeber 12. Einen Eingang des Komparators 11 bildet eine Leitung 13, die zu einem Frequenzumsetzer 14 führt, den anderen Eingang des Komparators bildet eine Leitung 15, die zu einem Potentiometer 16 als Sollwertgeber führt. Auf den beiden Eingängen 17 und 18 des Frequenzumsetzers 14 liegen Frequenzsignale an, auf der Leitung 17 Signale einer Ist-Frequenz, die von einem Drehzahlgeber 19 kommen, der dem Motor 1 zugeordnet ist. Auf dem Eingang 18 liegt eine Referenz-Frequenz an, die beispielsweise von der Netz-Frequenz über eine Leitung 20 abgeleitet ist.

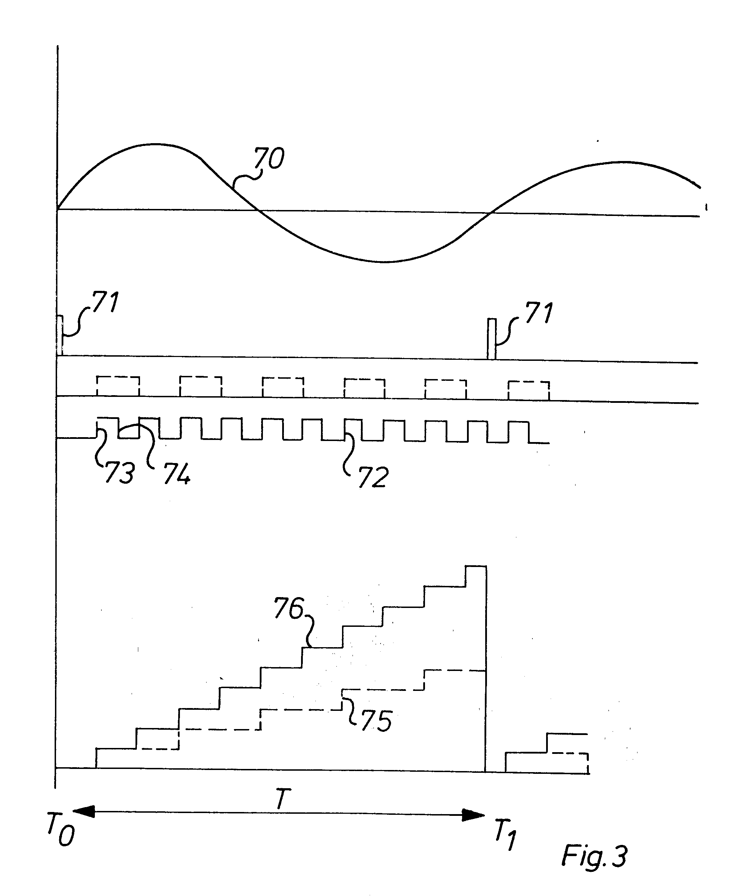

Das erfindungsgemäße Verfahren wird nun anhand der Schaltung der Figur 2 in Verbindung mit dem Funktionsdiagramm der Figur 3 näher erläutert. Der Umsetzer 14 weist einen ersten elektronischen Schalter 30 auf, der beispielsweise die Emitter-Kollektorstrecke eines Transistors sein kann und der den Stromfluß im Zuge einer Leitung 31 zuläßt beziehungsweise unterbricht in Abhängigkeit von den Ist-Frequenzsignalen auf der Leitung 17, die als Spannungs- oder Stromwert an die Basis dieses Transistors geführt werden. Der Geber 19 kann zum Beispiel als Hallgenerator ausgeführt werden, der die Magnetpole eines Polrades abtastet, das an der Motorwelle angebracht ist. Er gibt auf seiner Leitung 17 entsprechende Signale unmittelbar ab. Im Zuge der Leitung 31 liegt ein Widerstand 32, der mit einem zweiten Widerstand 33 in Reihe liegt, der auf seiner anderen Seite an Masse liegt. An den Verbindungspunkt 34 beider Widerstände ist eine Leitung 35 angeschlossen, die zu einer Verzweigung 36 führt. An den Verzweigungspunkt 36 ist einmal eine Leitung 37 angeschlossen, die zu einem Kondensator 38 führt, zum zweiten ein weiterer elektronischer Schalter 39, der beispielsweise wieder als Transistor ausgeführt ist. Die an den Schalter anschließende Leitung 40 ist auf die von der Leitung 37 abgewandten Seite des Kondensators 38 geführt. Der elektronische Schalter 39 ist genauso wie ein weiterer elektronischer Schalter 41 im Takt der Referenz-Frequenz gesteuert, die auf der Leitung 18 ansteht. Da die Referenz-Frequenz von der Netz-Frequenz abgeleitet ist, schließen und öffnen die beiden Schalter 39 und 41 völlig synchron im Takt der Netz-Frequenz. Beide Schalter 39 und 41 schließen gemeinsam für eine Zeit von einigen Mikrosekunden bei jedem zweiten Nulldurchgang der Netzspannung. Der elektronische Schalter 41 liegt einerseits an Masse, andererseits an einer Leitung 42, die zu einer Verzweigung 43 führt. Von der Verzweigung 43 führt eine Leitung 44 zu einer weiteren Verzweigung 45, von der über eine Leitung 46 ein weiterer Kondensator 47 an Masse gelegt ist. Eine weitere von der Verzweigung 45 abgehende Leitung 48 ist über eine in Sperrichtung geschaltete Diode 49 mit einem Ausgang 50 eines Operationsverstärkers 51 verbunden. Zwischen der Diode 49 und der Verzweigung 45 liegt eine weitere Verzweigung 52, von der eine Leitung einmal mit dem invertierenden Eingang 53 des Operationsverstärkers 51, zum anderen mit dem nicht invertierenden Eingang 54 eines zweiten Operationsverstärkers 55 verbunden ist, dessen Ausgang über eine Leitung 56, die eine in Durchlaßrichtung geschaltete Diode 57 aufweist, mit einer Verzweigung 58 verbunden ist. Von der Verzweigung 58 geht eine erste Leitung 59 aus, die einmal an den invertierenden Eingang des Operationsverstärkers 55 und zum zweiten an den nicht invertierenden Eingang 60 des Operationsverstärkers 51 führt. Eine weitere Leitung 61 führt von der Verzweigung 58 zu der Verzweigung 62, an die einmal die Leitung 40 und zum anderen der Kondensator 38 angeschlossen sind. Die Verzweigung 43 liegt im Zuge der Leitung 13, wobei in der Leitung 13 ein Spannungsfolger 63 liegt.

Die Beschaltung der beiden Operationsverstärker 51 und 55 ist insoweit unvollständig, als sie ideale Operationsverstärker voraussetzt, bei denen die zwischen den Punkten 52 und 58 herrschende Offsetspannung Null ist.

Das über die Netzimpulse auf der Leitung 18 bewirkte periodische Öffnen und Schließen der beiden elektronischen Schalter 39 und 41 - es könnte auch ein Vielfaches der einzelnen Halb-Perioden der Netzspannung sein - bewirken ein kurzzeitiges Entladen der beiden Kondensatoren 38 und 47. Die Schließzeit der beiden Schalter 39 und 41 beträgt nur einige Mikrosekunden und ist kurz gegenüber allen anderen noch zu behandelnden Zeiten des Verfahrens.

Der elektronische Schalter 30 wird im Takt der Drehzahl des Motors 1 betätigt, so daß der Schalter 30 den Stromfluß in der Leitung 31 im Takt der Motordrehzahl unterbricht beziehungsweise freigibt. Damit wird der Spannungsteiler, bestehend aus den Widerständen 32 und 33, periodisch an Spannung gelegt beziehungsweise von ihr abgeschaltet.

Die Leitung 31 führt zu einer Spannungsquelle, die die Betriebsspannungsquelle der gesamten in der Figur 2 dargestellten Schaltung sein kann oder eine sonstige Referenzspannungsquelle.

Die Anzahl der Öffnungs- und Schließvorgänge des Schalters 30 soll zwischen zwei Schließvorgängen der Schalter 39 und 41 möglichst groß sein, weil hiervon die Genauigkeit des Verarbeitungsverfahrens stark abhängt. Um dies zu verdeutlichen, ist in der Figur 3 die Zeit T dargestellt, die zwischen den Zeitpunkten T0 und T1 liegt. Die Netz-Frequenz ist durch die Kurve 70 repräsentiert. Bei jedem zweiten Null-Durchgang, nämlich zu den Zeitpunkten T0, T1...., entsteht ein Impuls 71, der zum Schließen der beiden Schalter 39 und 41 führt. Die Ist-Frequenz, mit der der Schalter 30 betätigt wird, ist durch die Impulsfolge 72 dargestellt. Man erkennt hieraus, daß innerhalb einer Periode T eine Vielzahl der Impulse des Drehzahlgebers 19 einläuft. Beim Auftreten der ersten positiven Flanke 73 des ersten Impulses 72 wird der Schalter 30 geschlossen. In dem Augenblick liegt ein Spannungswert entsprechend dem Teilerverhältnis durch die Widerstände 32 und 33 am Kondensator 38 an und wird von diesem auf den Verzweigungspunkt 58 gegeben. Die Kondensatoren 47 und 38 sind im Zeitpunkt T0 ungeladen gewesen, weil kurz vorher die Schalter 39 und 41 betätigt wurden, was zu einer Entladung der Kondensatoren führte. Beim Ansteigen des Spannungswertes im Verzweigungspunkt 58 wird der Spannungswert des Ausganges des Operationsverstärkers 55 auf der Leitung 56 Null, womit die Diode 57 sperrt. Andererseits wird der Ausgang 50 des Operationsverstärkers 51 positiv, der entsprechende Spannungswert wird über die leitende Diode 49 auf den Verzweigungspunkt 52 gedrückt. Damit wird der Kondensator 47 um den entsprechenden Wert geladen, wobei der Endwert der Ladung dem Spannungswert entspricht, der währenddessen am Verzweigungspunkt 58 herrscht. Damit ist nach Beendigung des Ladungsvorgangs des Kondensators 47 die Spannungsdifferenz zwischen den Verzweigungspunkten 58 und 52 Null. Wesentlich ist dabei, daß der Kondensator 38 durch den Vorgang nicht geladen wird, sondern im ungeladenen Zustand verbleibt. Nach Abklingen des ersten Impulses hat somit der Kondensator 47 seine erste Ladungsstufe erreicht, während der Kondensator 38 nach wie vor ungeladen bleibt. Hierbei ist für den Kondensator 47 wesentlich, daß unter dem Begriff Ladung nicht ein bestimmter Energieinhalt, sondern lediglich ein bestimmter Spannungswert verstanden wird. Die Genauigkeit der Schaltung ist damit nicht abhängig von den Kapazitätswerten der Kondensatoren 47 und 38, sondern lediglich von der Genauigkeit der Operationsverstärker 51 und 55 und dem Teilerverhältnis der Widerstände 32 und 33. Die Spannung, auf die der Kondensator 38 jeweils stufenweise aufgeladen wird beziehungsweise werden wird, hängt nur von der Teilspannung am Widerstand 33 ab und von der Genauigkeit, mit der aufgrund der Beschaltung der Operationsverstärker 51 und 55 die Beibehaltung dieses Spannungswerts verifiziert werden kann. Die Zeitkonstante des RC-Gliedes aus dem Kondensator 38 und dem Widerstand des Spannungsteilers 32, 33 muß klein gegenüber der Periodendauer der Frequenz des Istwertgebers sein.

Die Schaltung verharrt nunmehr in dem Zustand bis zum Auftreten der Rückflanke 74 des ersten Impulses. Hierbei öffnet der Schalter 30, der Spannungswert auf der Leitung 35 geht wieder gegen Null. Ein Absinken des Spannungsniveaus am Verzweigungspunkt 58 ist nicht möglich, da der dann aufsteuernde Operationsverstärker 55 das Spannungsniveau über die dann leitende Diode 57 aufrechterhält. Das gleiche Spannungsniveau am Verzweigungspunkt 52 bleibt erhalten, da der Kondensator 47 ein Absinken verhindert und weil andererseits der Ausgang 50 des Operationsverstärkers 51 Null wird, und damit sperrt die Diode 49.

Beim Öffnen des Schalters 30 beginnt ein Ladevorgang für den Kondensator 38, da dessen erster Anschluß am gleichbleibenden Spannungswert des Verzweigungspunktes 58 verbleibt, sein anderer Anschluß aber von dem auf Nullpotential gehenden Spannungsteileranschluß 34 bestimmt wird. Am Ende des Ladevorgangs weist der Kondensator 38 die gleiche Spannung wie der Kondensator 47 auf. Beim Auftreten weiterer Impulse des Istwertgebers und damit bei erneutem Schließen des Schalters 30 wiederholt sich dieser Vorgang so lange, bis der Zeitpunkt T1 erreicht ist. Somit klettert die an den Kondensatoren 47 und 38 anliegende Spannung in Form einer Treppenspannung vom Anfangswert Null auf einen Endwert, bis der Zeitpunkt T1 erreicht ist. Der Endwert ergibt sich aus der Anzahl der Stufen, das heißt der Anzahl der Impulse des Istwertgebers innerhalb der Zeitspanne T und der Stufenhöhe. Die Stufenanzahl entspricht unmittelbar dem Verhältnis der Frequenz des Istwertgebers und der Frequenz beziehungsweise ganzzahligen Teilen der doppelten Netzfrequenz der Netzspannung.

Ist die Drehzahl des Asynchronmotors 1 niedriger geworden, so ergeben sich bei gleicher Treppenstufenhöhe weniger Impulse, das heißt weniger Stufen. Dies ist durch die Kurve 75 angedeutet, die weniger Treppenstufen als die ursprünglich betrachtete Kurve 76 aufweist. Da die Treppenstufenhöhe unabhängig von der Treppenstufenanzahl ist, ist der erreichte Spannungsendwert kleiner. Dieser Spannungsendwert liegt auf der Leitung 13 am Ausgang der Schaltung gemäß Figur 2 an. Somit liegt am Ausgang 13 eine quasi analoge Spannung an, deren Höhe ein unmittelbares Maß für die Drehzahl des Motors ist.

Die Frequenz des Istwertgebers schwankt zwischen zwei Grenzwerten entsprechend dem Stellbereich der Motordrehzahlregelung, wobei der obere Grenzwert bei Asynchronmotoren durch die synchrone Drehzahl bestimmt wird.

Die synchrone Drehzahl $n_s$ ergibt sich bekanntlich aus der Netzfrequenz $f_N$ und der ganzzahligen Polpaarzahl p des Motors gemäß Gleichung (1).

$$(1) \qquad n_S = \frac{f_N}{p}$$

Sie ist die theoretische Obergrenze der Motordrehzahl. In der Praxis liegt die maximale Drehzahl bei ca. 95 % dieses Wertes, zum Beispiel 2.850 u/min bei $f_N = 50$ Hz und p = 1.

Es erweist sich als vorteilhaft, eine Istdrehzahl durch das Verhältnis dieser Istdrehzahl zur synchronen Drehzahl zu kennzeichnen. Bei Motoren liegt dieses Verhältnis stets zwischen 0 und 100 %.

Analog hierzu ist es ebenso zweckmäßig, die Stufenhöhe $\Delta U$ der Treppenspannung so festzulegen, daß bei maximaler Stufenanzahl, das heißt bei synchroner Drehzahl, die letzte Treppenstufe in ihrer Höhe einem elektrischen Referenzwert $U_{ref}$ entspricht, von dem gleichzeitig die Stufenhöhe $\Delta U$ abgeleitet ist. Als

Referenzwert kann beispielsweise die Betriebsspannung $U_B$ des Reglers dienen, wobei die Stufenhöhe $\Delta U$ durch das Teilerverhältnis des aus den Widerständen 32 und 33 gebildeten Spannungsteilers bestimmt wird. Die Leitung 31 wird dazu mit der Betriebsspannung $U_B$ verbunden. Das Verhältnis zwischen der Höhe der letzten Treppenstufe und der Betriebsspannung ist dann gleich dem Verhältnis der Istdrehzahl zur synchronen Drehzahl. Schwankungen der Betriebsspannung wirken sich auf die Funktionsweise nicht aus.

Aus diesen Festlegungen ergibt sich eine einfache Bemessungsregel für das Verhältnis $\Delta U/U_{ref}$ beziehungsweise das zu wählende Spannungsteilerverhältnis (32, 33) auf der Basis konstruktionsbedingter Vorgabedaten:

$$(2) \qquad \frac{\Delta U}{U_{ref}} = \frac{2p}{z \cdot n_0}$$

wobei

p die Polpaarzahl

$U_{ref}$ die Referenzspannung

z die Anzahl der Drehzahlgeberimpulse pro Motorumdrehung

$n_0$ die Anzahl der Netzhalbwellen zwischen dem Beginn und dem Ende der Treppenkurve

bedeuten.

Es versteht sich von selbst, daß auch andere Festlegungen getroffen werden können. Weil bei sehr niedrigen Drehzahlen nur wenige Impulse 72 vom Istwertgeber ankommen, ist es aus Genauigkeitsgründen zweckmäßig, eine untere Drehzahl-Stellbereichsgrenze nicht zu unterschreiten. Will man einen Asynchronmotor auf relativ kleine Drehzahlbereiche regeln, so müßte man, um hier Abhilfe zu schaffen, entweder die Periodendauer T vergrößern oder die Anzahl der Istwertimpulse pro Umdrehung des Motors durch zusätzliche Mittel vergrößern.

Während mit dem Verhältnis der Ist-Frequenz, bezogen auf die Referenz-Frequenz, die auf der Leitung 13 anstehende Spannung variabel ist, ist das andere Verhältnis, nämlich das Verhältnis dieser Spannung zu einem elektrischen Referenzwert, durch das Verhältnis der einzelnen Stufenhöhe zu diesem Referenzwert gegeben.

Für die weitere Erklärung der Funktion der Anwendung des Verfahrens bei einer Drehzahlregelung wird jetzt wieder die Figur 1 herangezogen, wobei an den Eingängen des Komparators 11 einmal die an der Leitung 13 anstehende Treppenspannung und zum anderen ein Sollwert über den Geber 16 ansteht. Der Komparator schaltet jeweils durch, wenn die Treppe den Soll-Spannungswert überschreitet. Die Ausgangsspannung des Komparators 11 wird eine Rechteck-Spannung sein. Diese Rechteck-Spannung wird ein Pulspausenverhältnis von 1 haben, wenn der Sollwert die Hälfte des Treppenendwertes ausmacht. Diese Rechteck-Spannung wird im Integrator 9 integriert. Der Vergleichsspannungsgeber 12 dient dazu, den Integrator 9 mit der halben Betriebsspannung zu beaufschlagen. Die volle Betriebsspannung entspricht den Betriebsspannungen, an denen der Integrator 9 und der Komparator 11 liegen. Damit entspricht das maximale Ausgangssignal des Komparators 11 dieser Betriebsspannung. Am Ausgang 8 des Integrators steht somit eine Regelspannung an. Der Umsetzer 5 setzt die Regelspannung 8 in einen Phasenwinkel um, zu dem die Zündimpulse für den Triac 4 auftreten. Diese Variation des Phasenwinkels führt dann zu einer Drehzahlveränderung des Asynchronmotors in dem Sinne, daß dessen Regelabweichung gegen Null geht. Eine ansteigende Steuerspannung auf der Leitung 8 verkleinert den Zündwinkel des Triacs 4, damit wird die Drehzahl erhöht.

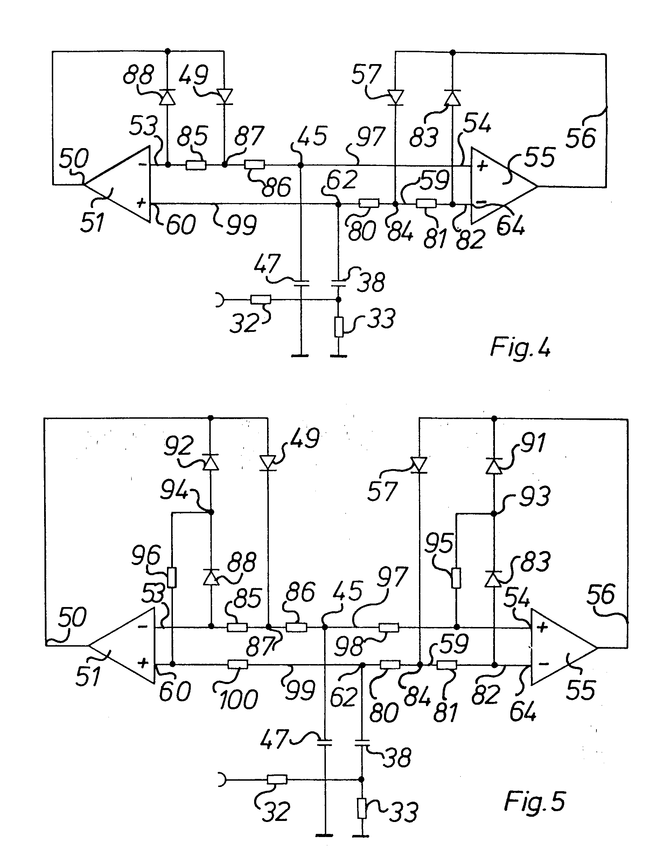

Ausgehend von der Tatsache, daß bei dem Schaltbild nach Figur 2 ideale Operationsverstärker 51 und 55 vorausgesetzt wurden, diese aber praktisch nicht vorhanden sind, wurde die Schaltung nach Figur 2 gemäß den in Figuren 4 und 5 dargestellten Schaltungen modifiziert. Im Rahmen der Figur 4 ist in die Leitung 59 eine Reihenschaltung zweier Widerstände 80 und 81 eingeschaltet, wobei der Widerstand 81 mit dem invertierenden Eingang 82 des Operationsverstärkers 55 verbunden ist, der seinerseits über eine in Durchlaßrichtung geschaltete Diode 83 mit der Leitung 56 verbunden ist. Der Verbindungspunkt 84 zwischen den beiden Widerständen 80 und 81 ist mit der Kathode der Diode 57 verbunden. Der Widerstand 81 ist relativ hochohmig gegenüber dem Widerstand 80, und zwar etwa im Verhältnis von $1:10^2$ bis $1:10^3$.

Der Punkt 45 ist mit dem invertierenden Eingang 53 des Operationsverstärkers 51 gleichermaßen über eine Serienschaltung zweier Widerstände 85 und 86 verbunden, wobei der Verbindungspunkt 87 beider Widerstände über die in Sperrichtung geschaltete Diode 49 mit dem Ausgang 50 des Operationsverstärkers 51 verbunden ist. Der invertierende Eingang 53 dieses Operationsverstärkers ist mit dem Widerstand 85 einerseits und über eine in Durchlaßrichtung geschaltete Diode 88 mit dem Ausgang 50 verbunden. Auch hier gilt, daß der Widerstand 85 im Verhältnis von $1:10^2$ bis $1:10^3$ größer ist als der Widerstand 86.

Die Widerstände 86 und 85 beziehungsweise 80 und 81 dienen als Ladewiderstände für die Kondensatoren 47 und 38.

Sie begrenzen den Ladestrom, führen andererseits aber zu einer zeitlichen Verlängerung des Ladevorganges. Kleine Zeitkonstanten sind jedoch zweckmäßig, weshalb man die Werte der Widerstande 80 und 86 möglichst klein wählen sollte. Eine zu kleine Wahl der Widerstandsgrößen stellt aber zu große Anforderungen an die Operationsverstärker und wirkt sich damit verteuernd aus.

Die Ladezeitkonstante für die Kondensatoren 47 und 38 muß klein gegenüber der niedrigstmöglichen Periodendauer bei maximaler Drehzahl des Asynchronmotors sein.

Um ein schnelles Kippen der Operationsverstärker 51 und 55 zu ermöglichen, sollen sie nicht in den Bereich der Sättigung gesteuert werden. Um das zu gewährleisten, sind die Dioden 88 und 83 vorgesehen, die die Operationsverstärker im aktiven Bereich halten. Um hier Ladungsabflüsse aus den Kondensatoren 38 und 47 zu vermeiden, sind die Widerstände 85 und 81 vorgesehen, die aus diesem Grunde relativ hochohmig gehalten werden. Eine Wahl zu hoher Werte für die Widerstandswerte der Widerstände 85 und 81 beeinträchtigt die Schaltgeschwindigkeit der Operationsverstärker, eine Wahl zu kleiner Werte verursacht eine zu große Entladung der Kondensatoren.

Die Unterschiede bezüglich der Schaltungen nach Figuren 4 und 5 liegen darin, daß die Dioden 83 und 88 in eine Serienschaltung von wenigstens zwei Dioden aufgespalten sind. Zu der Diode 83 ist eine Diode 91 und zu der Diode 88 eine Diode 92 in gleicher Richtung geschaltet. Die Verbindungspunkte 93 und 94 zwischen den jeweils in Serie liegenden Dioden sind über je einen Widerstand 95 und 96 mit den nicht invertierenden Eingängen 54 und 60 der beiden Operationsverstärker 51 und 55 verbunden. In die Verbindung 97 zwischen dem Punkt 45 und dem nicht invertierenden Eingang 54 des Operationsverstärkers 55 ist ein Widerstand 98, in die Verbindung 99 zwischen dem Punkt 62 und dem invertierenden Eingang 60 des Operationsverstärkers 51 ist ein Widerstand 100 eingeschleift. Durch die Widerstände werden Spannungsteiler gebildet, die einmal aus dem Widerstand 95 in Verbindung mit dem Widerstand 98 und aus dem Widerstand 96 in Verbindung mit dem Widerstand 100 bestehen, wobei der Verbindungspunkt beider Widerstände auf den jeweils nicht invertierenden Eingang des zugehörigen Operationsverstärkers gelegt ist. Hierdurch wird erreicht, daß bei einer gegenüber der Kondensatorspannung des zugehörigen Kondensators negativen Ausgangsspannung am zugehörigen Operationsverstärker die zugehörigen Dioden 88 und 92 oder 83 und 91 leiten und damit eine Mitkopplung über den Widerstand 96 beziehungsweise 95 des zugehörigen Spannungsteilers wirksam wird, die auf den nicht invertierenden Eingang des zugehörigen Operationsverstärkers einwirkt. Der Spannungsabfall an dem zugehörigen Widerstand 96 beziehungsweise 95 entspricht der Flußspannung der Diode 88 oder 83. Das Verhältnis der beiden Widerstände 96 und 100 beziehungsweise 95 und 98 ist so zu wählen, daß die am Widerstand 100 beziehungsweise 98 abfallende Spannung größer als die Offsetspannung des zugehörigen Operationsverstärkers ist.

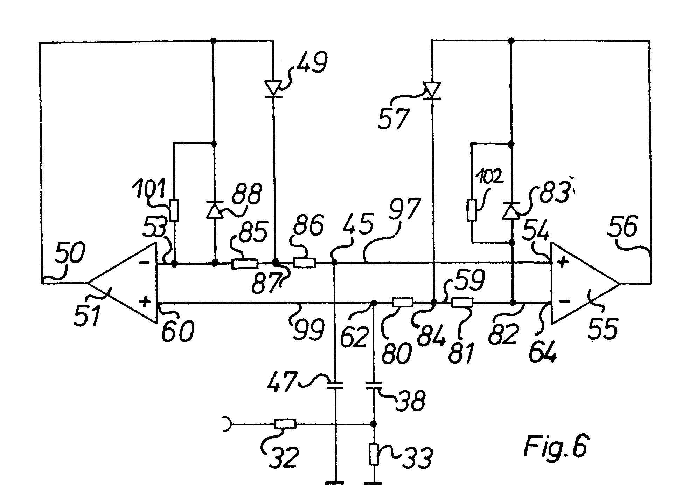

Ausgehend von der in Figur 4 dargestellten Schaltung sind in dem Ausführungsbeispiel nach Figur 6 den Dioden 83 und 88 Widerstände 101 und 102 parallelgeschaltet. Die Werte dieser Widerstände sind so zu wählen, daß im Ruhezustand der Schaltung die Spannungsabfälle an den Widerständen (101, 102) kleiner als die Durchlaßspannungen der zugehörigen Dioden 49 und 57 sind. Zu niedrige Werte dürfen andererseits auch nicht gewählt werden, damit die Funktion der Schaltung nicht beeinträchtigt wird. Je nach der Polarität der Summe der Offsetspannungen der beiden Operationsverstärker stellt sich im Ruhezustand, das heißt, wenn keiner der beiden Kondensatoren 38 und 47 geladen wird, eine positive oder negative Spannung an den Dioden 49 beziehungsweise 57 ein. Bei negativer Spannung fließt der geringe Diodensperrstrom, der in aller Regel vernachlässigt werden kann. Bei positiver Spannung über der Diode (49, 57) könnte ein betragsmäßig größerer Diodenstrom auftreten, der den zugehörigen Kondensator 38, 47 in unerwünschter Weise zusätzlich auflädt. Aufgabe der Widerstände 101, 102 ist es, die Diodenflußspannung auf so kleine Werte zu begrenzen, daß der verbleibende Diodenstrom vernachlässigt werden kann. Weiter wird vorausgesetzt, daß der durch die Widerstände 85 und 81 fließende, offsetspannungsbedingte Strom ebenfalls vernachlässigbar kleine Werte annimmt.

**Patentansprüche**

1. Verfahren zum Verarbeiten eines als Frequenz vorliegenden, zwischen einem höheren und einem niedrigeren Grenzwert schwankenden Meßwertes, aus dem ein variierendes elektrisches Spannungssignal, die Ist-Signalspannung, gebildet wird, welche zu einer vorgebbaren elektrischen Referenzspannung näherungsweise in folgender Beziehung steht:

$$\frac{\text{Ist-Signalspannung}}{\text{Referenzspannung}} = \frac{\text{Ist-Frequenz}}{\text{Referenzfrequenz}} \, ,$$

wobei für diskrete Meßpunkte exakte Geltung besteht, dadurch gekennzeichnet, daß als vorgebbare elektrische Referenzspannung eine nicht notwendig erweise konstante Spannung, insbesondere eine Betriebsspannung, verwendet wird.

2. Verfahren nach Anspruch 1, dadurch gekennzeichnet, daß eine Treppenspannung gebildet wird, wobei die Stufenzahl der Treppe dem Frequenzverhältnis

$$\frac{\text{Ist-Frequenz}}{\text{Referenzfrequenz}}$$

entspricht und die Stufenhöhe ($\Delta$U) von der vorgebbaren elektrischen Referenzspannung abgeleitet ist.

3. Verfahren nach Anspruch 2, dadurch gekennzeichnet, daß die Stufenhöhe ($\Delta$U) in einem festen Verhältnis zur elektrischen Referenzspannung steht.

4. Verfahren nach einem der Ansprüche 1 bis 3, dadurch gekennzeichnet, daß es auf eine Drehzahlregelung eines Asynchronmotors angewendet wird.

5. Verfahren nach einem der Ansprüche 1 bis 3, dadurch gekennzeichnet, daß der Beginn der Treppe und das Ende der Treppe durch von der Netzfrequenz abgeleitete Zeitpunkte definiert sind.

6. Verfahren nach Anspruch 5, dadurch gekennzeichnet, daß als Zeitpunkte für den Beginn und das Ende der Treppe Nulldurchgänge der Netzspannung gewählt sind.

7. Verfahren nach einem der Ansprüche 1 bis 3 und 5 bis 6, dadurch gekennzeichnet, daß die Frequenz der Ist-Signalspannung vervielfacht, insbesondere verdoppelt wird.

8. Verfahren nach Anspruch 4, dadurch gekennzeichnet, daß sich das Verhältnis der Höhe ($\Delta$U) einer Treppenstufe zur Höhe der vorgebbaren elektrischen Referenzspannung ($U_{ref}$) verhält wie die doppelte Polpaarzahl des Asynchronmotors zu dem Produkt aus der Anzahl der Impulse eines Ist-Wert-Gebers pro Umdrehung des Motors und der Anzahl der Netzhalbwellen zwischen dem Beginn und dem Ende der Treppenkurve, wenn Nulldurchgänge der Netzspannung als Zeitpunkte für den Beginn beziehungsweise das Ende der Treppenkurve gewählt sind.

9. Schaltung zur Durchführung des Verfahrens nach einem der Ansprüche 1 - 3, mit einer Referenz-Spannungsquelle, an der eine vorgebbare elektrische Referenzspannung abnehmbar ist, mit zwei Kondensatoren (47, 38), von denen der eine an Masse liegt und mit Entladekreisen (39,40,41,42) für die Kondensatoren, gekennzeichnet durch zwei miteinander über die jeweils zueinander inversen Eingänge verbundene Operationsverstärker (51, 55), wobei die beiden Eingangspaare mit je einem der Kondensatoren (47, 38) beschaltet sind, von denen der andere mit einer Wechselspannungsquelle (30 - 34) verbunden ist, die pro Periode der Frequenz eines Ist-Wert-Gebers (19) einen positiven und einen negativen Spannungs-Extremwert erzeugt, wobei die Differenz zwischen dem positiven und dem negativen Extremwert der Spannung dieser Wechselspannungsquelle ein konstanter, vorgegebener Teil der elektrischen Referenzspannung ist und wobei jeder Operationsverstärker (51, 55) mit einer von seinem Ausgang (56, 50) zu seinem invertierenden Eingang (53, 64) in Durchlaßrichtung geschalteten

EP 0 193 212 B1

Diode (57, 49) beschaltet ist, wobei die Entladekreise (39, 40, 41, 42) mit einem Eingang (18) der Schaltung verbunden sind, der mit einer Referenzfrequenz gespeist ist, und wobei die Kondensatoren (47, 38) periodisch im Takt der Referenzfrequenz entladen werden und eine Ist-Signalspannung an einem der beiden Kondensatoren (47, 38) abgenommen wird.

10. Schaltung nach Anspruch 9, dadurch gekennzeichnet, daß parallel zu der in Durchlaßrichtung geschalteten Diode (49, 57) eine Reihenschaltung, bestehend aus einem Widerstand (85, 81) und einer gegenläufig geschalteten Diode (88, 83) angeordnet ist, wobei der invertierende Eingang (53 oder 64) an den Verbindungspunkt zwischen dem Widerstand (85, 81) und der gegenläufig geschalteten Diode (88, 83) angeschlossen ist.

11. Schaltung nach Anspruch 10, dadurch gekennzeichnet, daß der Verbindungspunkt zwischen der in Durchlaßrichtung geschalteten Diode (49, 57) und dem Widerstand (85, 81) über je einen Widerstand (86, 80) mit dem zugehörigen Kondensator (47, 38) verbunden ist.

12. Schaltung nach Anspruch 10 oder 11, dadurch gekennzeichnet, daß die gegenläufig geschaltete Diode als Serienschaltung von zwei Dioden (83, 91, 88, 92) ausgeführt ist und daß der Verbindungspunkt (93, 94) beider Dioden (83, 91, 88, 92) über einen Widerstand (95, 96) an den nicht invertierenden Eingang des zugehörigen Operationsverstärkers (51, 55) gelegt ist.

13. Schaltung nach Anspruch 10, dadurch gekennzeichnet, daß zu der gegenläufig geschalteten Diode (83, 88) ein Widerstand (101, 102) parallelgeschaltet ist.

**Claims**

1. A method of processing a measured value which is available as a frequency and varies an upper limit and a lower limit and from which a varying voltage signal is derived, which constitutes the actual voltage and is related approximately as follows to a predeterminable reference voltage:

$$\frac{\text{actual signal voltage}}{\text{reference voltage}} = \frac{\text{actual frequency}}{\text{reference frequency}}$$

with exact validity for discrete measuring points, characterized in that a voltage which is not necessarily constant, particularly a supply voltage, is used as a predeterminable reference voltage.

2. A method according to claim 1, characterized in that a staircase voltage is generated having steps in a number which corresponds to the frequency ratio

$$\frac{\text{actual frequency}}{\text{reference frequency}}$$

and the step height ($\Delta U$) is derived from the predeterminable reference voltage.

3. A method according to claim 2, characterized in that the step height ($\Delta U$) has a fixed relation to the reference voltage.

4. A method according to any of claims 1 to 3, characterized in that it is used for a speed control of a non-synchronous motor.

5. A process according to any of claims 1 to 3, characterized in that the beginning and end of the staircase are defined by instants which are derived from the mains frequency.

6. A method according to claim 5, characterized in that zero crossings of the mains frequency are selected as instants for the beginning and end of the staircase.

9

**7.** A method according to any of claims 1 to 3 and 5 to 6, characterized in that the frequency of the actual signal voltage is multiplied, particularly doubled.

**8.** A method according to claim 4, characterized in that the ratio of the height ($\Delta U$) of a step of the staircase is related to the value of the predeterminable reference voltage ($U_{ref}$) like twice the number of poles of the non-synchronous motor to the product of the number of pulses of an actual value signal generator per revolution of the motor and the number of the mains half-waves between the beginning and the end of the staircase curve, provided that zero crossings of the mains voltage are selected as instants of the beginning and end of the staircase curve.

**9.** A circuit for carrying out the method according to any of claims 1 to 3, comprising a reference voltage source, from which a predeterminable reference voltage can be taken, also comprising two capacitors (47, 38), one of which is grounded, and comprising circuits (39, 40, 41, 42) for discharging the capacitors, characterized by two operational amplifiers (51, 55), which are connected by those of their inputs which are inverse to each other, wherein the two pairs of inputs are connected to respective ones of the capacitors (47, 38), the other of which is connected to an alternating voltage source (30 to 34), which generates a positive peak voltage and a negative peak voltage per period of the frequency of an actual-value signal generator (19), the difference between the positive and negative voltage peaks of said alternating voltage source is a predetermined constant part of the reference voltage, and each operational amplifier (51, 55) is connected to forwardly conducting diode (57, 49), which is connected from the output (56, 50) to the inverting input (53, 64) of said operational amplifier, the discharging circuits (39, 40, 41, 42) are connected to one input (18) of the voltage, which input (18) is fed with a reference frequency, the capacitors (47, 38) are periodically discharged in step with the reference frequency, and an actual signal voltage is taken from one of the two capacitors (47, 38).

**10.** A circuit according to claim 9, characterized in that a series circuit consisting of a resistor (85, 81) and a reversely conducting diode (88, 83) is connected in parallel to the forwardly conducting diode (49, 57), the inverting input (53 or 64) is connected to the junction between the resistor (85, 81) and the reversely conducting diode (88, 83).

**11.** A circuit according to claim 10, characterized in that the junction between the forwardly conducting diode (49, 57) and the resistor (85, 81) is connected by respective resistors (86, 80) to the associated capacitors (47, 38).

**12.** A circuit according to claim 10 or 11, characterized in that the reversely conducting diode is constituted by a series connection of two diodes (83, 91, 88, 92) and the junction (93, 94) of the two diodes (83, 91, 88, 92) is connected by a resistor (95, 96) to the non-inverting input of the associated operational amplifier (51, 55).

**13.** A circuit according to claim 10, characterized in that a resistor (101, 102) is connected in parallel to the reversely conducting diode (83, 88).

**Revendications**

**1.** Procédé pour le traitement d'une valeur de mesure sous forme d'une fréquence oscillant entre une valeur limite supérieure et une valeur limite inférieure, pour créer un signal de tension électrique variable, soit la tension effective, qui se trouve vis-à-vis d'une tension électrique de référence préréglable approximativement dans le rapport suivant:

$$\frac{\text{Tension effective}}{\text{Tension de réf.}} = \frac{\text{Fréquence effective}}{\text{Fréquence de réf.}}$$

avec une validité précise pour des points de mesure discrets, caractérisé par le fait que la tension électrique de référence préréglable est une tension qui n'est pas absolument constante, de préférence une tension de service.

**2.** Procédé suivant la revendication 1, caractérisé par le fait qu'il est formé une tension échelonnée, le nombre d'échelons correspondant au rapport des fréquences

$$\frac{\text{Fréquence effective}}{\text{Fréquence de réf.}}$$

et la hauteur des échelons (ΔU) étant déduite de la tension de référence préréglable.

**3.** Procédé suivant la revendication 2, caractérisé par le fait que la hauteur des échelons (ΔU) se trouve dans un rapport fixe vis-à-vis de la tension de référence.

**4.** Procédé suivant l'une des revendications 1 à 3, caractérisé par le fait qu'il est utilisé pour la régulation de la vitesse d'un moteur asynchrone.

**5.** Procédé suivant l'une des revendications 1 à 3, caractérisé par le fait que le début et la fin de l' escalier sont définis par des temps déduits de la fréquence du secteur.

**6.** Procédé suivant la revendication 5, caractérisé par le fait que les temps pour le début et la fin de l' escalier sont définis par des passages par zéro de la tension du secteur.

**7.** Procédé suivant l'une des revendications 1 à 3 et 5 à 6, caractérisé par le fait que la fréquence de la tension effective du signal est multipliée, notamment doublée.

**8.** Procédé suivant la revendication 4, caractérisé par le fait que le rapport de la hauteur (ΔU) d'un échelon vis-à-vis de la hauteur de la tension de référence ($U_{ref}$) préréglable est égal au rapport entre le nombre double de paires de pôles du moteur asynchrone et le produit du nombre des impulsions émis par un capteur de mesure par tour du moteur, par le nombre des demi-ondes du secteur entre le début et la fin de la courbe en escalier, si les passages par zéro de la tension secteur sont pris pour déterminer le début ou la fin de la courbe en escalier.

**9.** Montage pour l'application du procédé suivant l'une des revendications 1 à 3, avec une source de tension de référence où peut être prélevée une tension de référence préréglable, avec deux condensateurs (47, 38) dont l'un est mis à la masse, et avec des circuits de décharge (39, 40, 41, 42) pour les condensateurs, caractérisé par deux amplis opérationnels (51, 55) reliés entre eux par leurs entrées inverseuses l'une par rapport à l'autre, les deux paires d'entrées étant connectés chacun à l'un des condensateurs (47, 38) dont l'autre est relié à une source de tension alternative (30 - 34) qui produit par période de la fréquence d'un capteur de mesure (19) une tension extrême positive et négative, la différence entre les valeurs extrêmes positive et négative de la tension débitée par ladite source étant une partie constante préréglée de la tension de référence, et chaque ampli opérationnel (51, 55) étant connecté à une diode (57, 49) conductrice entre sa sortie (56, 50) et son entrée inverseuse (53, 64), les circuits de décharge (39, 40, 41, 42) étant reliés à une entrée (18) du montage, laquelle est alimentée en une fréquence de référence, et les condensateurs (47, 38) étant périodiquement déchargés à la cadence de la fréquence de référence, et une tension effective étant prélevée sur l'un des condensateurs (47, 38).

**10.** Montage suivant la revendication 9, caractérisé par le fait qu'il est prévu, parallèlement à la diode (49, 57) montée dans le sens de conduction, un montage en série comprenant une résistance (85, 81) et une diode (88, 83) montée en sens inverse, l'entrée inverseuse (53 ou 64) étant reliée au point de jonction entre la résistance (85, 81) et la diode (88, 83) montée en sens inverse.

**11.** Montage suivant la revendication 10, caractérisé par le fait que le point de jonction entre la diode (49, 57) montée dans le sens de conduction, et la résistance (85, 81) est relié au condensateur (47, 38) correspondant, par l'intermédiaire d'une résistance (86, 80).

**12.** Montage suivant la revendication 10 ou 11, caractérisé par le fait que la diode montée en sens inverse est réalisée comme montage en série de deux diodes (83, 91, 88, 92) et que le point de jonction (93, 94) des deux diodes (83, 91, 88, 92) est relié à l' entrée non inverseuse de l'ampli opérationnel (51, 55)

11

correspondant, par l'intermédiaire d'une résistance (95, 96).

13. Montage suivant la revendication 10, caractérisé par le fait qu'une résistance (101, 102) est mise en parallèle avec la diode (83, 88) montée en sens inverse.

EP 0 193 212 B1

*Fig.1*

*Fig. 2*

EP 0 193 212 B1

Fig. 3

14

Fig. 4

Fig. 5

Fig.6